# EUROPEAN PATENT APPLICATION

(11) **EP 1 577 418 A1**
(43) Date of publication of application: **21.09.2005**
(21) Application number: 03782805.0
(22) Date of filing: 18.12.2003
(51) Int. Cl.: C23C 14/34, C23C 14/00, B01J 3/00

(54) **POLYGONAL BARREL SPATTERING DEVICE, POLYGONAL BARREL SPATTERING METHOD, COATED PARTICLE FORMED BY THE DEVICE AND METHOD, MICROCAPSULE, AND METHOD OF MANUFACTURING THE MICROCAPSULE**

(30) Priority: 25.12.2002 JP 2002374111; 11.03.2003 JP 2003064695
(71) Applicant: Youtec Co., Ltd., Chiba 270-0156 (JP)
(72) Inventor: ABE, Takayuki, c/o Hydrogen Isotope Res. Center, Toyama-shi, Toyama 930-8555 (JP); WATANABE, K., c/o Hydrogen Isotope Res. Center, Toyama-shi, Toyama 930-8555 (JP); HONDA, Yuuji, c/o Youtec Co., Ltd., Nagareyama-shi, Chiba 270-0156 (JP)
(74) Representative: Viering, Jentschura & Partner
(86) International application number: PCT/JP2003/016244
(87) International publication number: WO 2004/059031

(57) **Abstract**

The present invention relates to a polygonal barrel sputtering device and a polygonal barrel sputtering method for coating surfaces of fine particles with ultra-fine particles having a grain diameter smaller than the particles or thin films, a coated fine particle formed by the device and method, a micro capsule and a method for producing the micro capsule. The polygonal barrel sputtering method according to the present invention comprises a step for containing fine particles 3 in a vacuum container 1 having a polygonal internal shape on a cross section, which is substantially parallel with a gravitational direction, and a step for performing sputtering while stirring or rolling the fine particles 3 contained in the vacuum container 1 by rotating the vacuum container 1 about a rotating axis, which is substantially perpendicular to the cross section, whereby surface of the fine particle 3 is coated with ultra-fine particles having a grain diameter smaller than the fine particle or thin films.

## Description

### Field of the Invention

The present invention relates to a polygonal barrel sputtering device and a polygonal barrel sputtering method for coating surfaces of fine particles with ultra-fine particles having a grain diameter smaller than the particles or thin films, a coated fine particle formed by the device and method, a micro capsule and a method for producing the micro capsule.

### Background of the Invention

Fine particles are an attractive material in the fundamental field and the application field so as to be applied to various uses. For example, fineness of fine particles is used to form cosmetic foundation. And, ferrite fine particles which form a single magnetic domain are used to a magnetic material with which a magnetic tape is coated. In addition, fine particles characterized by a large specific surface area are used to produce particle catalysts. As just described, fine particles are a material having a very large potential. Consequentially, a technology for developing a new material has been required in which surfaces of fine particles are modified with a functional material so as to demonstrate high functionality and new feature.

As an example of such technology, the ferrite particles coated with Co films for the purpose of increasing coercive force of the ferrite fine particles have been developed. However, substantial progress on development of such technology for modifying the powder surfaces has not been seen because of difficulties in handling of particles and modifying entire surface of each particle uniformly.

A conventionally used method for modifying powder surfaces includes a substitution electroplating method, an electrolytic plating method, a chemical vapor deposition method and a vacuum deposition method. However, the substitution electroplating method and the electrolytic plating method may cause damage on the environment because it is necessary to treat discharged highly toxic waste fluid. And, the chemical vapor deposition method has complicated processes corresponding to kinds of materials, whereby operating conditions are restricted. In addition, in the vacuum deposition method, it is difficult to coat powder surfaces with thin films uniformly. Thus, such conventionally used methods for modifying powder surfaces cannot form a designed powder material.

In order to solve the above-mentioned problems, an object of the present invention is to provide a polygonal barrel sputtering device and a polygonal barrel sputtering method, which does not require treating waste fluid like a plating method and damage on the environment, coated fine particles formed by the device and method, a micro capsule and a method for producing the micro capsule.

### Disclosure of the Invention

In order to solve the problems, the inventors have paid attention to a sputtering method which is one of physical vapor deposition methods. Although it is difficult to coat entire surface of each particle with fine particles uniformly in the sputtering method, the sputtering method has very high versatility such as the following: any carrier can be used; surfaces of particles can be modified with various substances including metal and inorganic material; and further, environmental damage is low. Consequentially, the inventors developed a polygonal barrel sputtering method, in which a polygonal barrel containing fine particles is rotated so that the particles can be stirred or rolled so as to be modified at the surfaces thereof uniformly.

Hereinafter, the present invention will be described in detail.

A polygonal barrel sputtering device according to the present invention comprises a vacuum container for containing fine particles which has a polygonal internal shape on a cross section substantially parallel with a gravitational direction, a rotating mechanism for rotating the vacuum container about a rotating axis which is substantially perpendicular to the cross section, and a sputtering target arranged in the vacuum container, wherein sputtering is preformed while stirring or rolling the fine particles in the vacuum container by rotating the vacuum container using the rotating mechanism so that surface of the fine particle will be coated with ultra-fine particles having a grain diameter smaller than the fine particle or thin films.

In the polygonal barrel sputtering device, since the vacuum container is rotated about a rotating axis which is substantially perpendicular to a cross section substantially parallel with a gravitational direction (i.e., a substantially horizontal direction), the fine particle itself is rolled and stirred. And, the vacuum container having a polygonal internal shape enables the fine particles contained therein to fall periodically by gravity. This can improve stirring efficiency remarkably and therefore prevent aggregation of the fine particles owing to moisture and electrostatic force, in which such aggregation often leads to a problem in handling fine particles. In other words, rotating the vacuum container carries out simultaneously stirring fine particles and decomposing aggregated fine particles. Accordingly, it becomes possible that fine particles having a very small grain diameter are coated with ultra-fine particles having a grain diameter smaller than the fine particle or thin films. And, unlike a plating method requiring treatment of waste fluid, the polygonal barrel sputtering device according to the present invention does not damage the environment.

In the present invention, the sputtering device may further comprise a vibrator for vibrating the vacuum container, thereby preventing problematic aggregation of fine particles more effectively.

And, in the present invention, the polygonal barrel sputtering device may further comprise a heater for heating the fine particles contained in the vacuum container. For example, when air is evacuated from the vacuum container, heating the vacuum container using the heater can evaporate and discharge moisture absorbed on the interior surface of the vacuum container or the surfaces of the fine particles contained therein. Accordingly, moisture, which becomes an obstacle to handle fine particles, can be discharged from the vacuum container so that aggregation of the fine particles can be effectively prevented.

Furthermore, in the present invention, the polygonal barrel sputtering device may further comprise a rod-like member contained in the vacuum container, wherein the rod-like member vibrates the fine particles so as to promote stirring and rolling the fine particles while the vacuum container is being rotated. The rod-like member also works to decompose aggregated fine particles. Here, the rod-like member may be various-shaped members, such as a screw, as long as the member provides vibration to the fine particles.

A polygonal barrel sputtering method according to the present invention comprises a step for containing fine particles in a vacuum container having a polygonal internal shape on a cross section, which is substantially parallel with a gravitational direction, and a step for performing sputtering while stirring or rolling the fine particles contained in the vacuum container by rotating the vacuum container about a rotating axis, which is substantially perpendicular to the cross section, whereby surface of the fine particle is coated with ultra-fine particles having a grain diameter smaller than the fine particle or thin films.

In the polygonal barrel sputtering method, since the vacuum container is rotated about a rotating axis which is substantially perpendicular to a cross section substantially parallel with a gravitational direction (i.e., a substantially horizontal direction), the fine particle can be rolled and stirred. And, the vacuum container having a polygonal internal shape enables the fine particles to fall periodically by gravity, thereby improving stirring efficiency remarkably and therefore preventing aggregation of the fine particles owing to moisture and electrostatic force, in which such aggregation often leads to a problem in handling fine particles. In other words, rotating the vacuum container can carry out simultaneously stirring fine particles and decomposing aggregated fine particles. Accordingly, it becomes possible that fine particles having a very small grain diameter are coated with ultra-fine particles having a grain diameter smaller than the fine particle or thin films. And, unlike a plating method requiring treatment of waste fluid, the environment is not damaged.

A polygonal barrel sputtering method according to the present invention comprises a step for containing fine particles in a vacuum container having a polygonal internal shape on a cross section and a step for performing sputtering while stirring or rolling the fine particles contained in the vacuum container by rotating the vacuum container about a rotating axis, which is substantially perpendicular to the cross section, and also vibrating the fine particles, whereby surface of the fine particle is coated with ultra-fine particles having a grain diameter smaller than the fine particle or thin films.

A polygonal barrel sputtering method according to the present invention comprises a step for containing fine particles in a vacuum container having a polygonal internal shape on a cross section and a step for performing sputtering while stirring or rolling the fine particles contained in the vacuum container by rotating the vacuum container about a rotating axis, which is substantially perpendicular to the cross section, and also heating the vacuum container, whereby surface of the fine particle is coated with ultra-fine particles having a grain diameter smaller than the fine particle or thin films.

A coated fine particle according to the present invention is formed such that sputtering is performed while stirring or rolling the fine particles contained in a vacuum container having a polygonal internal shape on a cross section by rotating the vacuum container about a rotating axis, which is substantially perpendicular to the cross section, whereby surface of the fine particle are coated with ultra-fine particles having a grain diameter smaller than the fine particle or thin films.

A coated fine particle according to the present invention is formed such that sputtering is performed while stirring or rolling the fine particles contained in a vacuum container having a polygonal internal shape on a cross section by rotating the vacuum container about a rotating axis, which is substantially perpendicular to the cross section, and also vibrating the fine particles, whereby surface of the fine particle is coated with ultra-fine particles having a grain diameter smaller than the fine particle or thin films.

A coated fine particle according to the present invention is formed such that sputtering is performed while heating a vacuum container containing fine particles therein having a polygonal internal shape on a cross section and also stirring or rolling the fine particles contained in the vacuum container by rotating the vacuum container about a rotating axis, which is substantially perpendicular to the cross section, whereby surface of the fine particle is coated with ultra-fine particles having a grain diameter smaller than the fine particle or thin films.

In the present invention, the ultra-fine particles or the thin films are made of any one of polymeric material, inorganic material, metallic material, alloy material and carbon material. For example, the carbon material such as fullerene, nanotube, diamond and activate carbon can be used.

In the present invention, the fine particle is made of ceramics and the ultra-fine particles or the thin films are made of any one of catalytic substance, electrochemical catalytic substance, optical functional substance, magnetic functional substance and electric and electronic functional substance. For example, the optical functional substance includes cosmetics and paint.

And, for example, when Al₂O₃ particle is coated with Pt or Pd, the coated particle can have the same catalytic performance and electrode performance as Pt bulk or Pd bulk.

And, in a coated fine particle according to the present invention, the fine particle is made of any one of polymeric material, organic material, metallic material, inorganic material and carbon material.

In addition, in the present invention, the fine particle preferably has a grain diameter of 5µm or less. The fine particle having a grain diameter of 5µm or more is also used in the present invention.

And, for example, when polymeric particle is coated with Pt, the polymeric particle can be provided with conducting property. Thus, such coated particle is applicable to a conductive spacer used in a liquid crystal display panel.

A producing method of a micro capsule according to the present invention comprises a step for containing fine particles in a vacuum container having a polygonal internal shape on a cross section substantially parallel with a gravitational direction, a step for performing sputtering while stirring or rolling the fine particles contained in the vacuum container by rotating the vacuum container about a rotating axis, which is substantially perpendicular to the cross section, whereby surface of the fine particle is coated with ultra-fine particles having a grain diameter smaller than the fine particle or thin films, and a step for removing the fine particle, which is a base of the coated fine particle, from the coated fine particle.

In this invention, the fine particle may be removed from the coated fine particle by dissolving or evaporating.

A producing method of a micro capsule according to the present invention comprises a step for containing fine particles in a vacuum container having a polygonal internal shape on a cross section, a step for performing sputtering while stirring or rolling the fine particles contained in the vacuum container by rotating the vacuum container about a rotating axis, which is substantially perpendicular to the cross section, and also vibrating the fine particles, whereby surface of the fine particle is coated with ultra-fine particles having a grain diameter smaller than the fine particle or thin films, and a step for removing the fine particle, which is a base of the coated fine particle, from the coated fine particle.

A producing method of a micro capsule according to the present invention comprises a step for containing fine particles in a vacuum container having a polygonal internal shape on a cross section, a step for performing sputtering while heating the vacuum container and also stirring or rolling the fine particles contained in the vacuum container by rotating the vacuum container about a rotating axis, which is substantially perpendicular to the cross section, whereby surface of the fine particle is coated with ultra-fine particles having a grain diameter smaller than the fine particle or thin films, and a step for removing the fine particle, which is a base of the coated fine particle, from the coated fine particle.

A micro capsule according to the present invention is made such that fine particles are contained in a vacuum container having a polygonal internal shape on a cross section, and sputtering is performed while stirring or rolling the fine particles contained in the vacuum container by rotating the vacuum container about a rotating axis, which is substantially perpendicular to the cross section, whereby surface of the fine particle is coated with ultra-fine particles having a grain diameter smaller than the fine particle or thin films and then the fine particle, which is a base of the coated fine particle, is removed from the coated fine particle.

A micro capsule according to the present invention is made such that fine particles are contained in a vacuum container having a polygonal internal shape on a cross section, and sputtering is performed while stirring or rolling the fine particles contained in the vacuum container by rotating the vacuum container about a rotating axis, which is substantially perpendicular to the cross section, and also vibrating the fine particles, whereby surface of the fine particle is coated with ultra-fine particles having a grain diameter smaller than the fine particle or thin films and then the fine particle, which is a base the coated fine particle, is removed from the coated fine particle.

A micro capsule according to the present invention is made such that fine particles are contained in a vacuum container having a polygonal internal shape on a cross section, and sputtering is performed while heating the vacuum container and also stirring or rolling the fine particles contained in the vacuum container by rotating the vacuum container about a rotating axis, which is substantially perpendicular to the cross section, whereby surface of the fine particle is coated with ultra-fine particles having a grain diameter smaller than the fine particle or thin films and then the fine particle, which is a base of the coated fine particle, is removed from the coated fine particle.

As described above, according to the present invention, a polygonal barrel sputtering device and a polygonal barrel sputtering method in which treatment of waste fluid like a plating method is not required and damage to the environment is small, a coated fine particle formed by the device and the method, a micro capsule and a method for producing the micro capsule can be provided.

### Brief Description of the Drawings

Fig.1 is a drawing schematically showing a structure of a polygonal barrel sputtering device according to one embodiment of the present invention.
Fig.2A is a photograph showing fine particles (powder sample) before performing sputtering and coated fine particles after performing sputtering and Fig.2B is an optical microscopic photograph showing fine particles (powder sample) before performing sputtering and coated fine particles after performing sputtering.
Fig.3A is a SEM photograph (500 magnifications) showing Al₂O₃ fine particles coated with Pt and Fig.3B is an element mapping of Al obtained by the analysis using EDS and Fig.3C is an element mapping of Pt obtained by the analysis using EDS.
Fig.4A is a SEM photograph (5000 magnifications) showing Al₂O₃ fine particles coated with Pt and Fig.4B is an element mapping of Al obtained by the analysis using EDS and Fig.4C is an element mapping of Pt obtained by the analysis using EDS.
Fig.5A is a drawing showing a current-voltage curve of Al₂O₃ fine particles coated with Pt in 1N H₂SO₄ and Fig.5B is a drawing showing a current-voltage curve of 1φ Pt disk electrode in 1N H₂SO₄.

### Detailed Description of Embodiment of the Invention

Hereinafter, the preferred embodiments of the present invention will be described in detail with reference to the accompanying drawings.

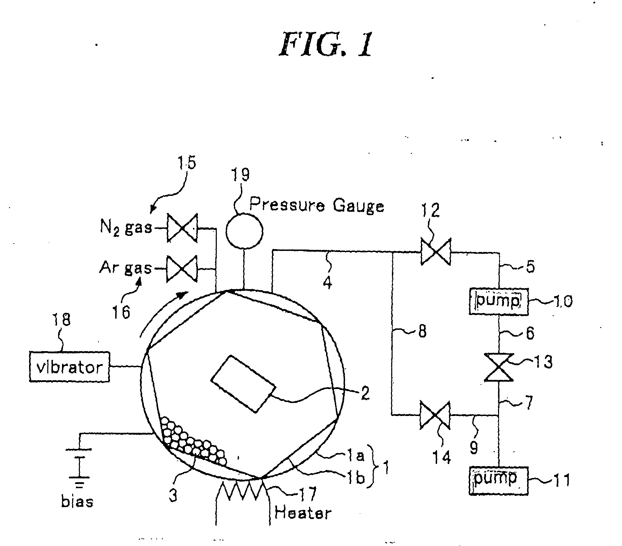

Fig.1 is a drawing schematically showing a structure of a polygonal barrel sputtering device according to one embodiment of the present invention. The polygonal barrel sputtering device is a device for coating surfaces of fine particles (powder) with ultra-fine particles having a grain diameter smaller than the fine particles or thin films.

The polygonal barrel sputtering device is equipped with a vacuum container 1 for coating fine particles (powder sample) 3 with ultra-fine particles or thin films. The vacuum container 1 is provided with a cylindrical body 1a having a diameter of 200mm and a barrel (hexagonal barrel) 1b having a hexagonal cross section arranged in the cylindrical body 1a. Here, the cross section is substantially parallel with a gravitational direction. In this embodiment, the cross sectional shape of the barrel 1b is a hexagon; however, the cross sectional shape may be not only a hexagon but also another polygonal.

The vacuum container 1 is equipped with a rotating mechanism (not shown) for rotating the hexagonal barrel 1b in a direction shown by an arrow in Fig. 1 so that a process for coating the fine particles are performed while rolling or stirring the fine particles (powder sample) 3 contained in the hexagonal barrel 1b. The rotating mechanism rotates the hexagonal barrel 1b about a rotating axis parallel with a substantial horizontal direction (a direction perpendicular to a gravitational direction). In the vacuum container 1, a sputtering target 2 made of Pt is arranged on a central axis of the cylindrical body 1a. Since the spattering target 2 is arranged so as to very corresponding to any angle, when the coating treatment is performed while rotating the hexagonal barrel 1b, the target 2 can be faced to the powder sample 3. This allows improvement in sputtering yield. This embodiment uses Pt as a target; however, another materials (for example, Pd and Ni) can coat the fine particles. In such a case, a target made of the coated material with the fine particle is used.

The vacuum container 1 is connected to one end of a pipe 4 and the other end of the pipe 4 is connected to one port of a first valve 12. And, the other port of the first valve 12 is connected to one end of a pipe 5. The other end of the pipe 5 is connected to an inlet port of a turbo molecular pump (TMP) 10. An outlet port of the turbo molecular pump 10 is connected to one end of a pipe 6 and the other end of the pipe 6 is connected to one port of a second valve 13. The other port of the second valve 13 is connected to one end of a pipe 7, and the other end of the pipe 7 is connected to a pump (RP) 11. And, the pipe 4 is connected to one end of a pipe 8, and the other end of the pipe 8 is connected to one port of a third valve 14. The other port of the third valve 14 is connected to one end of a pipe 9, and the other end of the pipe 9 is connected to the pipe 7.

The device according to the present invention has a heater 17 for heating the powder sample 3 in the vacuum container 1. The device further has a vibrator 18 for vibrating the powder sample 3 in the vacuum container 1. In addition, the device is provided with a pressure gauge 19 for measuring a pressure in the vacuum container 1. And, the device is provided with a nitrogen gas supplying unit 15 for introducing nitrogen gas into the vacuum container 1 and an argon gas supplying unit 16 for introducing argon gas into the vacuum container 1. And, the device is further provided with a high frequency wave applying unit (not shown) for applying high frequency between the target 2 and the hexagonal barrel 1b.

Next, a polygonal barrel sputtering method for coating the fine particles 3 with ultra-fine particles or thin films using the polygonal barrel sputtering device will be explained.

Initially, powder sample 3 of about 6g was introduced into the hexagonal barrel 1b. As the powder sample 3, α-Al₂O₃ (manufactured by Nilaco. Co. Ltd., four nines) having a size of 120 mesh was used. And, as the target 2, Pt was used. This embodiment used the Al₂O₃ powder but was not limited thereto. So, powder other than the Al₂O₃ powder could be used. The polygonal barrel sputtering method according to the present invention makes it possible to coat various types of powder with ultra-fine particles or thin films.

Then, by using the turbo molecular pump 10, a high vacuum region in the hexagonal barrel 1b was formed and then pressure inside the hexagonal barrel was decreased down to 5×10⁻⁴Pa while heating the hexagonal barrel up to 200°C using the heater 17. Then, from the argon gas supplying unit 16 or the nitrogen gas supplying unit 15, inert gas such as argon and nitrogen was introduced into the hexagonal barrel 1b. In this case, pressure in the hexagonal barrel 1b was about 2Pa. If necessary, mixed gas of oxygen and hydrogen might be introduced into the hexagonal barrel 1b. And, the hexagonal barrel 1b was rotated for 30 minutes at 20rpm by the rotating mechanism using 100W so as to roll and stir the powder sample 3 in the hexagonal barrel 1b. During the rotation, the target was being faced to a position in which the powder sample existed. Then, a high frequency wave was applied between the target 2 and the hexagonal barrel 1b using the high frequency applying unit, whereby surfaces of the powder samples 3 were coated with Pt by sputtering. This process allowed the surfaces of the powder sample 3 to be coated with ultra-fine particles or thin films.

According to this embodiment, rotating the hexagonal barrel allows the powder itself to be rolled and stirred. In addition, since the barrel has a hexagonal shape, the powder contained therein can periodically fall by gravity. This can improve stirring efficiency remarkably and therefore prevent aggregation of the fine particles owing to moisture and electrostatic force, in which such aggregation often leads to a problem in handling fine particles. In other wards, stirring the fine particles and decomposing the aggregated fine particles will be performed simultaneously. Accordingly, it becomes possible that a fine particle having a very small grain diameter is coated with ultra-fine particles having a grain diameter smaller than the fine particle or thin films. In particular, it becomes possible that a fine particle having a grain diameter of 5µm or less is coated with ultra-fine particles or thin films.

Furthermore, in this embodiment of the present invention, the vacuum container 1 has, at the outer surface thereof, the heater 17 capable of heating the hexagonal barrel 1b up to 200°C. Thus, when the vacuum container 1 is evaporated, the hexagonal barrel 1b is heated using the heater 17 so that moisture in the hexagonal barrel can be vaporized and discharged. Therefore, since moisture, which leads to a problem in handling such powders, can be removed from the inside of the hexagonal barrel, aggregation of the powder will be prevented effectively.

In this embodiment, the vacuum container 1 also has, at the outer surface thereof, the vibrator 18 capable of vibrating the powder 3 contained in the hexagonal barrel. Therefore, aggregation of the powder, which leads to a problem in handling such powders, will be prevented effectively.

In addition, in this embodiment, since the surface of the powder sample 3 is coated with fine particles using the polygonal barrel sputtering method, treatment of waste fluid like a plating method is not required and therefore environment is not damaged.

In addition, this embodiment uses the vibrator 18 for vibrating the powder 3 in the hexagonal barrel. However, in exchange for the vibrator 18 or in addition to the vibrator 18, the powder sample 3 can be vibrated in such a manner that the hexagonal barrel containing a rod-like member therein is rotated. This allows preventing problematic aggregation of the powder.

Next, microscopic observation of the modified samples (coated fine particles), in which surface of Al₂O₃ powder is coated with ultra-fine Pt particles using the polygonal barrel sputtering method, and electrochemical behavior thereof will be explained.

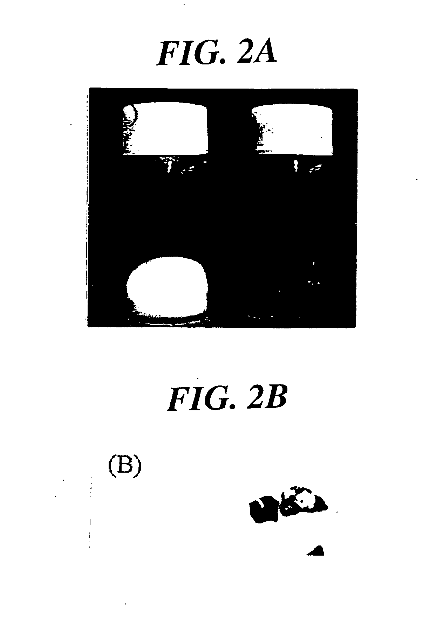

Fig.2A is a photograph showing fine particles (powder sample) before performing sputtering and coated fine particles after performing sputtering.

Fig.2A shows that Al₂O₃ powder before performing sputtering shows a white and translucent color, whereas coated Al₂O₃ powder after performing sputtering shows a metallic luster. And, since white particles are not observed in the coated powder after sputtering, all of the fine particles are expected to be uniformly coated with Pt.

Fig.2B is an optical microscopic photograph showing fine particles (powder sample) before performing sputtering and coated fine particles after performing sputtering.

Fig.2B show that both of the fine particles show a lustrous plane and edge. Fine particles before performing sputtering, shown in the left of Fig.2B, show a translucent color whereas fine particles after performing sputtering, shown in the right of Fig.2B, show a metallic color on the entire surfaces thereof. In addition, the fine particles after performing sputtering entirely show uniform metallic color and therefore seem to be coated with uniform films over the surface of the powder (surfaces of the fine particles).

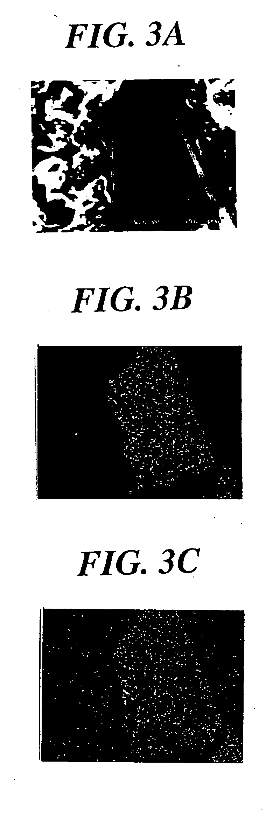

In order to examine the feature of Pt with which the powder is coated, the surface of the coated powder is examined by a scanning electron microscope (SEM, 500 magnifications). The observation results are shown in Figs.3.

Fig.3A is a SEM photograph (500 magnifications) showing Al₂O₃ fine particles coated with Pt. Fig.3A shows that the fine particles have a square pole shape formed of flat planes and sharp edges and the cross section thereof is partially not flat.

The Al₂O₃ fine particles coated with Pt are elementary-analyzed using EDS. The analysis is shown in Figs.3B and 3C. Fig.3B is an element mapping of A1 obtained by the analysis using EDS and Fig.3C is an element mapping of Pt obtained by the analysis using EDS. In Figs.3B and 3C, the surface concentration of each element is represented by color depth of blue and white.

Fig.3B shows that Al elements are uniformly distributed over the particle. It is supposed that the reason that Al concentration becomes low at the side surface of the particle is due to incline of the side surface. On the contrary, as shown in Fig.3C, Pt is uniformly detected all over the all particle, although its concentration is not as high as that of Al.

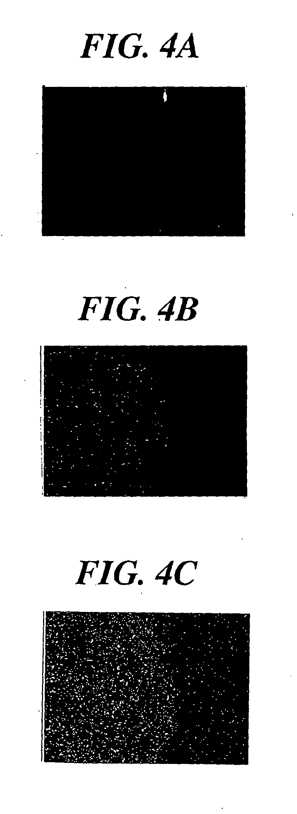

In addition, in order to examine the feature of Pt with which the surfaces of the particles are coated in detail, the surface of sample specimen is observed with a larger magnification (5000 magnifications). The observation results are shown in Figs.4.

Fig.4A is a SEM photograph (5000 magnifications) showing Al₂O₃ fine particles coated with Pt. In Fig.4A, the left side with higher contrast shows the surface of the particles. The photograph shows that the surfaces of the particles are significantly flat. In addition, the photograph shows that several fine particles having a grain diameter of 1µm or less exist on the surfaces of the particles. The reason will be described later.

Elementary analysis was performed using EDS on the Al₂O₃ fine particles coated with Pt. The analysis is shown in Figs.4B and 4C. Fig.4B is an element mapping of Al obtained from the analysis using EDS and Fig.4C is an element mapping of Pt obtained from the analysis using EDS.

Fig.4B shows that Al elements are distributed uniformly along the surfaces of the particles. Fig.4C shows that Pt elements are distributed on the surfaces of the particles although concentration thereof is lower compared with A1. And, it shows that the particles are coated with Pt elements to the tip of edge portions thereof.

In view of the results, it is found that Pt elements modifying the surfaces of the particles coat the entire surfaces of the particles like film but unlike island shaped spots. And, as a result of elemental analysis on the fine particles which exist on the surfaces of the particles like spots, such fine particles are not either A1 or Pt and seem to be debris mixed during sample preparation. The same result is obtained from another prepared particles. So, it can be said that all of the particles are coated with uniform Pt films.

Next, in order to examine electrochemical behavior of the Pt film, cyclic voltammetry CV was measured. CV was measured using a three-pole electrode comprising a Pt line as a counter electrode and a saturated calomel electrode as a reference electrode in 1N H₂SO₄. An operative electrode was formed as described below.

Initially, powder prepared by a sputtering method was placed on a carbon felt and then a filter paper was overlapped thereon. And, the overlapped carbon felt and the filter paper and the counter electrode were sandwiched in between acryl plates and a carbon sheet as a terminal was also sandwiched in therebetween at the tip of the carbon felt. After one end of the carbon sheet was contacted to H₂SO₄, CV was measured. For a potentiometer, Model 1263A manufactured by SEIKO EG&G Instruments was used. A potential scanning rate was 20mV/sec, and a primary potential was applied to an open-circuit potential and varied in -240mV to 1200mV.

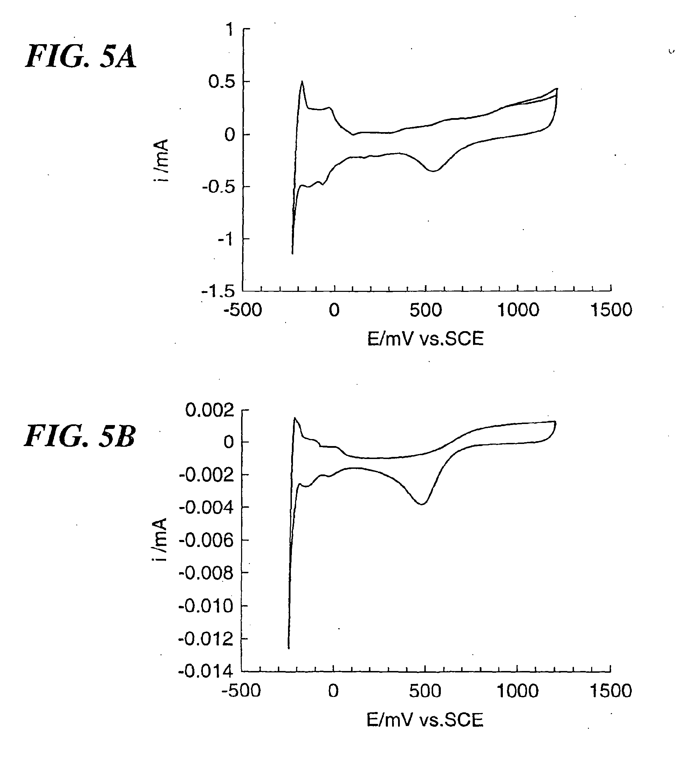

The CV measurements result is shown in Fig.5A. Fig.5A is a drawing showing a current-voltage curve of Al₂O₃ fine particles coated with Pt in 1N H₂SO₄. As a reference, CV of 1φ Pt disk electrode in the same solution is also shown in Fig.5B.

In both cases, peaks owing to hydrogen adsorption and desorption are observed near -50mV vs SCE and -150mV vs SCE. And, increasing of cathode current owing to generation of hydrogen is observed near -250mV. Furthermore, rising of anode current owing to generation of oxygen is observed near +1100mV and a peak based on reduction of PtO generated on the surfaces of Pt is observed near +500mV. From the results, it is found that the prepared Pt film with which Al₂O₃ fine particles are coated has the same electrochemical behavior as bulk Pt.

As described above, using the polygonal barrel sputtering device allows forming uniform Pt films on the surfaces of Al₂O₃ fine particles. And, since the Pt film has the same electrochemical behavior as bulk Pt, the polygonal barrel sputtering device is highly applicable to a surface coating method (a surface modifying method) of inorganic particles, polymeric particles and ionic crystal.

Next, a micro capsule according to the present invention will be explained. Such micro capsule is available for drag delivery as medicines.

Using a polygonal barrel sputtering device shown in Fig.1, surface of a fine particle is coated with ultra-fine particles having a grain diameter smaller than the fine particle or thin films according to the polygonal barrel sputtering method. In this case, for a material of the ultra-fine particle or the thin film, material suitable for the micro capsule is used.

Then, the fine particle, which is a base of the coated fine particle, is removed from the coated fine particle by dissolving or vaporization. This makes it possible to empty inside of the ultra-fine particles or the thin films with which the fine particle is coated. Accordingly, a micro capsule made of the ultra-fine particles or the thin films will be prepared.

The present invention is not be considered limited to what is shown in the drawings and described in the specification, and it will be appropriated that various changes can be made therein without departing from the scope of the invention. For example, a film forming condition for coating fine particles with thin films may be appropriately changed. And, it is possible that polymeric material, inorganic material, metallic material, alloy material and carbon material are used as a material of the ultra-fine particles or the thin films. And, when the fine particles are made of ceramics, it is possible that catalytic substance, electrochemical catalytic substance, optical functional substance (including cosmetics and paint), magnetic functional substance and electric and electronic functional substance are used as a material of the ultra-fine particles or the thin films. And, it is possible that polymeric material, organic material, metallic material, inorganic material and carbon material are used as a material of the fine particles.

## Claims

1. A polygonal barrel sputtering device comprising:
a vacuum container for containing fine particles which has a polygonal internal shape on a cross section substantially parallel with a gravitational direction;
a rotating mechanism for rotating said vacuum container about a rotating axis which is substantially perpendicular to said cross section; and
a sputtering target arranged in said vacuum container,
wherein sputtering is performed while stirring or rolling the fine particles in said vacuum container by rotating said vacuum container using said rotating mechanism so that surface of the fine particle is coated with ultra-fine particles having a grain diameter smaller than the fine particle or thin films.

2. A polygonal barrel sputtering device according to claim 1 further comprising a vibrator for vibrating said vacuum container.

3. A polygonal barrel sputtering device according to claim 1 or 2 further comprising a heater for heating the fine particles contained in said vacuum container.

4. A polygonal barrel sputtering device according to any one of claims 1 to 3 further comprising a rod-like member contained in said vacuum container, wherein said rod-like member vibrates the fine particles so as to promote stirring and rolling the fine particles while said vacuum container is being rotated.

5. A polygonal barrel sputtering method comprising:
a step for containing fine particles in a vacuum container having a polygonal internal shape on a cross section, which is substantially parallel with a gravitational direction; and
a step for performing sputtering while stirring or rolling the fine particles contained in said vacuum container by rotating said vacuum container about a rotating axis, which is substantially perpendicular to said cross section, whereby surface of the fine particle is coated with ultra-fine particles having a grain diameter smaller than the fine particle or thin films.

6. A polygonal barrel sputtering method comprising:
a step for containing fine particles in a vacuum container having a polygonal internal shape on a cross section; and
a step for performing sputtering while stirring or rolling the fine particles contained in said vacuum container by rotating said vacuum container about a rotating axis, which is substantially perpendicular to said cross section, and also vibrating the fine particles, whereby surface of the fine particle is coated with ultra-fine particles having a grain diameter smaller than the fine particle or thin films.

7. A polygonal barrel sputtering method comprising:
a step for containing fine particles in a vacuum container having a polygonal internal shape on a cross section; and
a step for performing sputtering while stirring or rolling the fine particles contained in said vacuum container by rotating said vacuum container about a rotating axis, which is substantially perpendicular to said cross section, and also heating said vacuum container, whereby surface of the fine particle is coated with ultra-fine particles having a grain diameter smaller than the fine particle or thin films.

8. A coated fine particle which is formed such that sputtering is performed while stirring or rolling the fine particles contained in a vacuum container having a polygonal internal shape on a cross section by rotating said vacuum container about a rotating axis, which is substantially perpendicular to said cross section, whereby surface of the fine particle is coated with ultra-fine particles having a grain diameter smaller than the fine particle or thin films.

9. A coated fine particle which is formed such that sputtering is performed while stirring or rolling the fine particles contained in a vacuum container having a polygonal internal shape on a cross section by rotating said vacuum container about a rotating axis, which is substantially perpendicular to said cross section, and also vibrating the fine particles, whereby surface of the fine particle is coated with ultra-fine particles having a grain diameter smaller than the fine particle or thin films.

10. A coated fine particle which is formed such that sputtering is performed while heating a vacuum container containing fine particles therein having a polygonal internal shape on a cross section and also stirring or rolling the fine particles contained in said vacuum container by rotating said vacuum container about a rotating axis, which is substantially perpendicular to said cross section, whereby surface of the fine particle is coated with ultra-fine particles having a grain diameter smaller than the fine particle or thin films.

11. A coated fine particle according to any one of claims 8 to 10, wherein said ultra-fine particles or said thin films are made of any one of polymeric material, inorganic material, metallic material, alloy material and carbon material.

12. A coated fine particle according to any one of claims 8 to 10, wherein said fine particle is made of ceramics and said ultra-fine particles or said thin films are made of any one of catalytic substance, electrochemical catalytic substance, optical functional substance, magnetic functional substance and electric and electronic functional substance.

13. A coated fine particle according to any one of claims 8 to 10, wherein said fine particle is made of any one of polymeric material, organic material, metallic material, inorganic material and carbon material.

14. A producing method of a micro capsule comprising:
a step for containing fine particles in a vacuum container having a polygonal internal shape on a cross section substantially parallel with a gravitational direction;
a step for performing sputtering while stirring or rolling the fine particles contained in said vacuum container by rotating said vacuum container about a rotating axis, which is substantially perpendicular to said cross section, whereby surface of the fine particle is coated with ultra-fine particles having a grain diameter smaller than the fine particle or thin films; and
a step for removing the fine particle, which is a base of the coated fine particle, from the coated fine particle.

15. A producing method of a micro capsule comprising:
a step for containing fine particles in a vacuum container having a polygonal internal shape on a cross section;
a step for performing sputtering while stirring or rolling the fine particles contained in said vacuum container by rotating said vacuum container about a rotating axis, which is substantially perpendicular to said cross section, and also vibrating the fine particles, whereby surface of the fine particle is coated with ultra-fine particles having a grain diameter smaller than the fine particle or thin films; and
a step for removing the fine particle, which is a base of the coated fine particle, from the coated fine particle.

16. A producing method of a micro capsule comprising:
a step for containing fine particles in a vacuum container having a polygonal internal shape on a cross section;
a step for performing sputtering while heating the vacuum container and also stirring or rolling the fine particles contained in said vacuum container by rotating said vacuum container about a rotating axis, which is substantially perpendicular to said cross section, whereby surface of the fine particle is coated with ultra-fine particles having a grain diameter smaller than the fine particle or thin films; and
a step for removing the fine particle, which is a base of the coated fine particle, from the coated fine particle.

17. A micro capsule which is made such that fine particles are contained in a vacuum container having a polygonal internal shape on a cross section, and sputtering is performed while stirring or rolling the fine particles contained in said vacuum container by rotating said vacuum container about a rotating axis, which is substantially perpendicular to said cross section, whereby surface of the fine particle is coated with ultra-fine particles having a grain diameter smaller than the fine particle or thin films and then the fine particle, which is a base of the coated fine particle, is removed from the coated fine particle.

18. A micro capsule which is made such that fine particles are contained in a vacuum container having a polygonal internal shape on a cross section, and sputtering is performed while stirring or rolling the fine particles contained in said vacuum container by rotating said vacuum container about a rotating axis, which is substantially perpendicular to said cross section, and also vibrating the fine particles, whereby surface of the fine particle is coated with ultra-fine particles having a grain diameter smaller than the fine particle or thin films and then the fine particle, which is a base the coated fine particle, is removed from the coated fine particle.

19. A micro capsule which is made such that fine particles are contained in a vacuum container having a polygonal internal shape on a cross section, and sputtering is performed while heating said vacuum container and also stirring or rolling the fine particles contained in said vacuum container by rotating the vacuum container about a rotating axis, which is substantially perpendicular to said cross section, whereby surface of the fine particle is coated with ultra-fine particles having a grain diameter smaller than the fine particle or thin films and then the fine particle, which is a base of the coated fine particle, is removed from the coated fine particle.
